# FASCICULE DE BREVET EUROPEEN

(11) **EP 2 419 749 B1**
(45) Date de publication et mention de la délivrance du brevet: **31.10.2018**
(21) Numéro de dépôt: 10715144.1
(22) Date de dépôt: 30.03.2010
(51) Int. Cl.: G01R 31/26, G01R 19/25

(54) **PROCEDE DE DIAGNOSTIC DE LA DEFAILLANCE D'UN GENERATEUR PHOTOVOLTAIQUE**
VERFAHREN ZUM DIAGNOSTIZIEREN DES AUSFALLS EINES PHOTOVOLTAIKGENERATORS
METHOD OF DIAGNOSING THE FAILURE OF A PHOTOVOLTAIC GENERATOR:

(30) Priorité: 17.04.2009 FR 0901886
(43) Date de publication de la demande: 22.02.2012
(73) Titulaire: Commissariat à l'Énergie Atomique et aux Énergies Alternatives, 75015 Paris (FR)
(72) Inventeur: CHAINTREUIL, Nicolas, F-73800 Montmelian (FR); BARRUEL, Franck, 73370 LE BOURGET DU LAC (FR); LABRUNIE, Antoine, F-75005 Paris (FR)
(74) Mandataire: Novaimo
(86) Numéro de dépôt international: PCT/EP2010/054240
(87) Numéro de publication internationale: WO 2010/118952

(56) Documents cités:
- WO-A-2004/090559
- US-A- 4 163 194
- US-A- 4 184 111
- US-A- 4 528 503

## Description

L'invention concerne un procédé de diagnostic pour un dispositif photovoltaïque permettant de détecter son dysfonctionnement. Elle est particulièrement adaptée à l'optimisation de la production d'un générateur photovoltaïque. Elle concerne aussi un dispositif photovoltaïque mettant en oeuvre un tel procédé.

Les dispositifs de génération d'énergie à partir de sources intermittentes, comme les générateurs photovoltaïques, sont de plus en plus utilisés. Le coût de leur production dépend de leur autonomie et de leur capacité à diagnostiquer leur défaillance, si possible en temps réel. Les dispositifs existants ne sont pas conçus pour une réaction rapide en cas de défaillance, même quand leur production devient anormalement basse. Pour cette raison, ils nécessitent des opérations de maintenance complexes et coûteuses.

La gestion classique des dispositifs photovoltaïques consiste à observer leur comportement au niveau des systèmes reliés à ces dispositifs, par exemple en mesurant la charge d'une batterie reliée au dispositif ou en mesurant la production électrique obtenue sur un réseau électrique auquel est relié le dispositif. En cas de mesure plus basse que la valeur attendue, il est conclu à une défaillance du dispositif photovoltaïque. Une telle gestion classique présente l'inconvénient d'être imprécise. En effet, elle ne permet pas de faire la distinction entre une baisse normale de production causée par des ombrages ou des conditions météorologiques particulières avec une réelle défaillance du dispositif. De plus, elle ne permet pas de différencier différentes défaillances du dispositif comme une augmentation de la résistance du câblage, par exemple suite à un défaut de connectique ou un arc électrique dans le dispositif, ou une détérioration de la face avant du générateur photovoltaïque, par exemple suite à une délamination ou à de la corrosion, à un ombrage ou à une salissure.
Le document WO2008112080 décrit une solution consistant à comparer des valeurs mesurées au niveau de modules photovoltaïques avec des valeurs préenregistrées dans une situation de fonctionnement normal pour détecter des défaillances. Une telle solution est lourde à mettre en oeuvre et n'est pas satisfaisante car elle exige un très grand nombre de données. Pour cela, il faut un grand nombre de capteurs pour réaliser un grand nombre de mesures, et un long traitement pour comparer ces mesures aux données enregistrées.

Le document US4163194 décrit un procédé de diagnostic comprenant la mesure de la tension aux bornes d'une cellule photovoltaïque lors du passage d'un mode en circuit ouvert vers un mode en court-circuit. Cependant ce procédé nécessite la mesure d'un paramètre supplémentaire, à savoir le courant ou la puissance. Ainsi, un objet général de l'invention est de proposer une solution de diagnostic pour un dispositif photovoltaïque qui ne comprend pas les inconvénients des solutions de l'état de la technique.
Plus précisément, l'invention cherche à atteindre tout ou partie des objets suivants :
Un premier objet de l'invention est de proposer une solution de diagnostic pour un dispositif photovoltaïque qui permet de détecter avec fiabilité et précision sa défaillance.
Un second objet de l'invention est de proposer une solution de diagnostic pour un dispositif photovoltaïque qui permet de détecter une défaillance à distance et en temps réel.
Un troisième objet de l'invention est de proposer une solution de diagnostic pour un dispositif photovoltaïque qui permet de détecter une défaillance de manière simple et économique.

A cet effet, l'invention repose sur un procédé de diagnostic pour un générateur photovoltaïque caractérisé en ce qu'il met en oeuvre une étape d'observation de l'évolution de sa tension en fonction du temps pendant qu'il passe d'un mode de fonctionnement en court-circuit à un mode en circuit ouvert ou réciproquement d'un mode de fonctionnement en circuit ouvert à un mode en court-circuit.

Pour cela, le procédé peut comprendre en outre une étape de mesure du temps normal nécessaire pour atteindre une tension maximale U_{CO} lorsque le générateur photovoltaïque passe d'un mode de fonctionnement en court-circuit à un mode en circuit ouvert dans un état non défectueux et/ou comprendre en outre une étape de mesure de la tension maximale U_{CO}.

L'étape de mesure de la tension maximale U_{CO} peut être réalisée après le passage du générateur photovoltaïque d'un mode de fonctionnement normal à un mode en circuit ouvert.

Il peut comprendre une étape de mesure du temps nécessaire pour atteindre un pourcentage prédéfini de la tension maximale U_{CO} lorsqu'il passe d'un mode de fonctionnement en court-circuit à un mode en circuit ouvert, et une étape de comparaison de ce temps avec le temps normal nécessaire dans le cas du générateur photovoltaïque en état de fonctionnement non défectueux, le générateur photovoltaïque étant considéré comme défectueux si ce temps dépasse un seuil prédéfini.

Le procédé peut comprendre une étape de mesure de la tension U aux bornes du générateur au bout d'un temps prédéfini lorsqu'il passe d'un mode de fonctionnement en court-circuit à un mode en circuit ouvert et une étape de comparaison de cette tension avec la tension normale atteinte dans le cas du générateur photovoltaïque en état de fonctionnement non défectueux, le générateur photovoltaïque étant considéré comme défectueux si cette tension est inférieure à un seuil prédéfini.

Pour cela, le procédé peut comprendre les étapes supplémentaires suivantes :
- ouverture d'un premier commutateur (en anglais switch) pour obtenir le passage du générateur photovoltaïque de la position de circuit fermé à celle de circuit ouvert, en le déconnectant de sa charge ;
- mesure de la tension maximale stabilisée, obtenue aux bornes du générateur photovoltaïque ;
- fermeture d'un second commutateur pour mettre le générateur photovoltaïque en court-circuit puis ouverture de ce second commutateur pour le remettre en circuit ouvert ;
- mesure de la tension aux bornes du générateur photovoltaïque obtenue au bout d'un temps prédéfini et comparaison de la tension mesurée avec la tension maximale pour déterminer l'état défectueux ou non du générateur photovoltaïque ;
- fermeture du premier commutateur pour remettre le générateur photovoltaïque dans sa situation de production électrique normale en liaison avec sa charge.

Le temps prédéfini peut être compris entre 10⁻⁷ et 10⁻² secondes et/ou le pourcentage prédéfini de la tension maximale U_{CO} peut être supérieur à 50 %.

En cas de diagnostic de la défaillance du générateur photovoltaïque, le procédé peut déterminer la courbe de l'évolution U(I) de sa tension U en fonction du courant I.

Selon un second mode d'exécution de l'invention, le procédé de diagnostic pour un générateur photovoltaïque est caractérisé en ce que l'étape d'observation de l'évolution de sa tension U comprend l'observation de l'évolution U(I) de sa tension U en fonction du courant I.

Le procédé peut comprendre une étape de détection des décrochements de la courbe tension-intensité pour en déduire le nombre de défauts ainsi que l'importance de la défaillance.

Le procédé de diagnostic pour un générateur photovoltaïque peut comprendre les étapes supplémentaires suivantes :
- ouverture d'un premier commutateur (en anglais switch) pour obtenir le passage du générateur photovoltaïque de la position de circuit fermé à celle de circuit ouvert, en le déconnectant de sa charge ;
- mesure de la tension maximale U_{CO} stabilisée, obtenue aux bornes du générateur photovoltaïque ;
- fermeture d'un second commutateur pour mettre le générateur photovoltaïque en court-circuit puis ouverture de ce second commutateur pour le remettre en circuit ouvert ;
- mesure de la tension U et du courant I aux bornes du générateur photovoltaïque jusqu'à ce que la tension U atteigne la tension maximale U_{CO} pour obtenir la courbe U(I) ;
- fermeture du premier commutateur pour remettre le générateur photovoltaïque dans sa situation de production électrique normale en liaison avec sa charge.

Le passage d'un mode de fonctionnement en court-circuit à un mode en circuit ouvert ou réciproquement peut être réalisé par un onduleur.

L'invention porte aussi sur un dispositif photovoltaïque comprenant un générateur photovoltaïque comprenant plusieurs cellules photovoltaïques, caractérisé en ce qu'il comprend au moins deux commutateurs pour permettre le passage d'au moins une cellule du générateur photovoltaïque d'un mode de fonctionnement en court-circuit à un mode en circuit ouvert ou réciproquement, et en ce qu'il comprend un microcontrôleur ou CPU mettant en oeuvre le procédé de diagnostic pour le générateur photovoltaïque tel que décrit précédemment.

Le premier commutateur peut être apte à relier ou non le générateur photovoltaïque à une charge extérieure comme une batterie ou un réseau électrique, et le au moins un second commutateur peut être en parallèle sur au moins une cellule du générateur photovoltaïque.

Le microcontrôleur ou CPU peut être celui d'un onduleur apte à relier le dispositif photovoltaïque à un réseau électrique ou le microcontrôleur ou CPU peut être intégré dans un boîtier disposé au niveau du générateur photovoltaïque.

Ces objets, caractéristiques et avantages de la présente invention seront exposés en détail dans la description suivante de modes d'exécution particuliers faits à titre non-limitatif en relation avec les figures jointes parmi lesquelles :
La figure 1 illustre schématiquement un circuit électrique équivalent à une cellule photovoltaïque.
La figure 2 représente la courbe tension-intensité obtenue aux bornes de différentes cellules photovoltaïques.
La figure 3 représente schématiquement le circuit électrique de deux cellules photovoltaïques en série dont une est défectueuse.
Les figures 4 et 5 représentent respectivement deux méthodes différentes de diagnostic d'un générateur photovoltaïque à partir des courbes d'évolution de la tension en fonction du temps aux bornes d'un générateur photovoltaïque normal et défectueux.
La figure 6 représente des courbes tension-intensité obtenues aux bornes d'un générateur photovoltaïque selon différents scenarii.
La figure 7 illustre un dispositif photovoltaïque selon un mode d'exécution de l'invention.
La figure 8 représente le circuit électrique mis en oeuvre pour le diagnostic du dispositif photovoltaïque selon le mode d'exécution de l'invention.

L'invention repose sur l'analyse de l'évolution de la tension d'un générateur photovoltaïque lors de son passage d'un mode de fonctionnement en court-circuit à un mode de fonctionnement en circuit ouvert ou réciproquement. Cette évolution peut être observée par la courbe de la tension en fonction du temps ou par l'analyse de la courbe représentant l'intensité en fonction de la tension au niveau du générateur photovoltaïque lors de ce changement de mode.

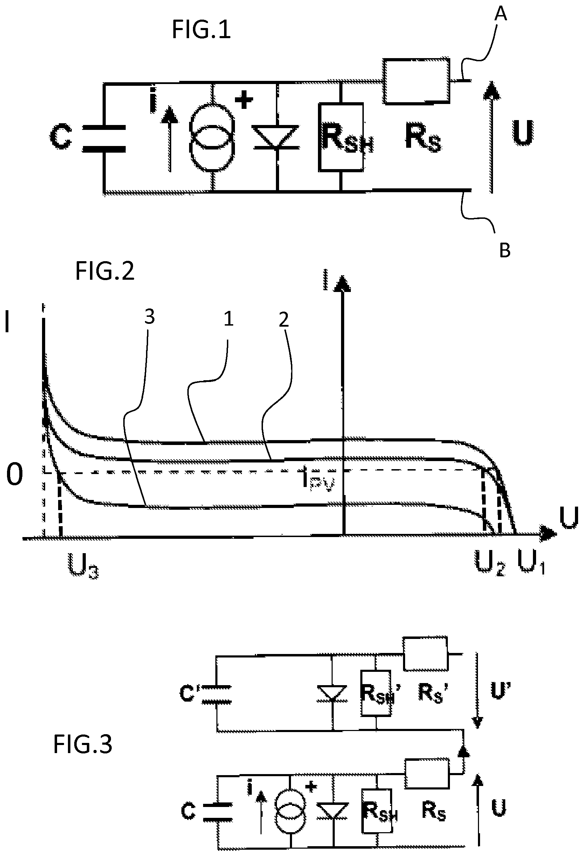

Une cellule photovoltaïque se comporte selon un circuit électrique tel que représenté schématiquement sur la figure 1. Elle fournit un courant I et une tension U sur ses bornes AB de sortie.

La figure 2 représente la courbe de l'intensité I en fonction de la tension U obtenue aux bornes de différentes cellules photovoltaïques. Les courbes 1 et 2 illustrent le cas de cellules photovoltaïques en fonctionnement normal, c'est-à-dire non défectueuses. La courbe 3 illustre la situation d'une cellule photovoltaïque recevant une irradiation insuffisante ou nulle, dite cellule défectueuse. Dans le cas où le courant fourni par un générateur photovoltaïque, qui comprend plusieurs de ces cellules photovoltaïques, s'élève à une valeur I_{PV}, les cellules photovoltaïques en position de fonctionnement normal vont présenter une tension U1, U2 positive à leurs bornes alors qu'une cellule défaillante présentera une tension U3 négative.

La figure 3 illustre schématiquement la représentation électrique d'une cellule en fonctionnement normal placée en série avec une cellule défaillante, dont la tension U' est opposée à la tension U de la cellule en état normal de fonctionnement. Dans une cellule photovoltaïque défectueuse, sa capacité C'est chargée négativement, sa tension opposée peut atteindre plus de 20 fois la valeur de la tension nominale de la cellule et son courant maximal est plus faible que celui d'une autre cellule. Dans le cas de l'ouverture du circuit relié à une telle cellule défectueuse, la tension de la cellule défectueuse va mettre un temps beaucoup plus long que celui d'une cellule normale pour atteindre une valeur nominale positive. Ce temps peut être de l'ordre de 20 à 100 fois plus long.

Ainsi, le concept de l'invention exploite le phénomène précédent pour élaborer, selon la réponse d'un générateur photovoltaïque lors de son passage d'un mode de court-circuit à circuit ouvert, un diagnostic de son fonctionnement.

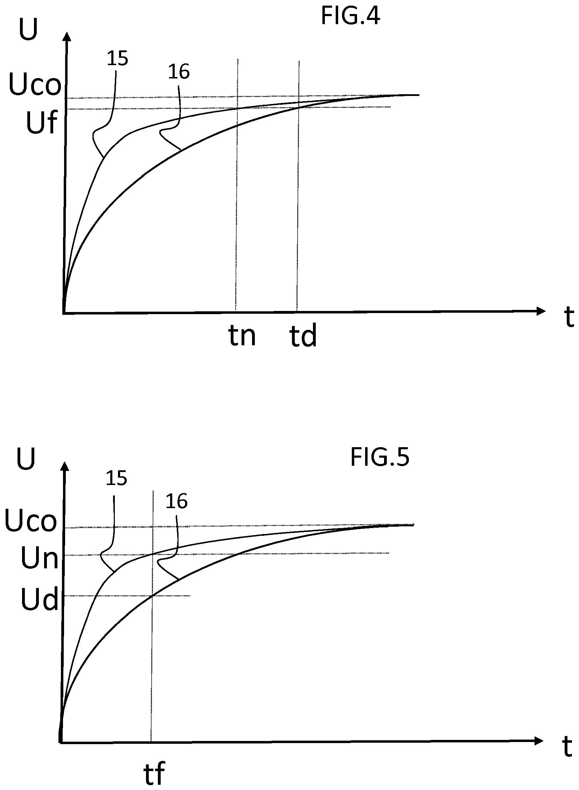

Les figures 4 et 5 représentent des courbes 15, 16 d'évolution de la tension U en fonction du temps t aux bornes d'un générateur photovoltaïque lors de son passage de court-circuit à circuit ouvert, respectivement dans le cas d'un fonctionnement normal et dans le cas d'un fonctionnement défectueux. La courbe normale 15 montre que la tension U converge finalement vers une tension maximale Uco. La courbe 16 montre que la tension d'un générateur défectueux augmente beaucoup moins vite.

Ainsi, une première méthode de diagnostic de l'état du générateur photovoltaïque, représentée sur la figure 4, consiste à observer le temps nécessaire pour atteindre une tension Uf représentant un pourcentage prédéfini de la tension maximale U_{CO}, par exemple 95%. Dans le cas du générateur en fonctionnement normal, la valeur finale prédéfinie Uf est atteinte au bout d'un temps normal tn. Dans le cas du générateur défectueux, la valeur finale prédéfinie Uf est atteinte au bout d'un temps plus long td. Ainsi, la comparaison des temps td et tn permet un diagnostic de l'état du générateur photovoltaïque.

Une seconde méthode, représentée sur la figure 5, consiste à mesurer la tension obtenue pour un temps prédéfini tf. Dans le cas du générateur en fonctionnement normal, une valeur normale Un est atteinte au bout du temps tf. Dans le cas du générateur défectueux, une valeur finale inférieure Ud est atteinte au bout du temps tf. Ainsi, la comparaison des tensions Un et Ud permet un diagnostic de l'état du générateur photovoltaïque.

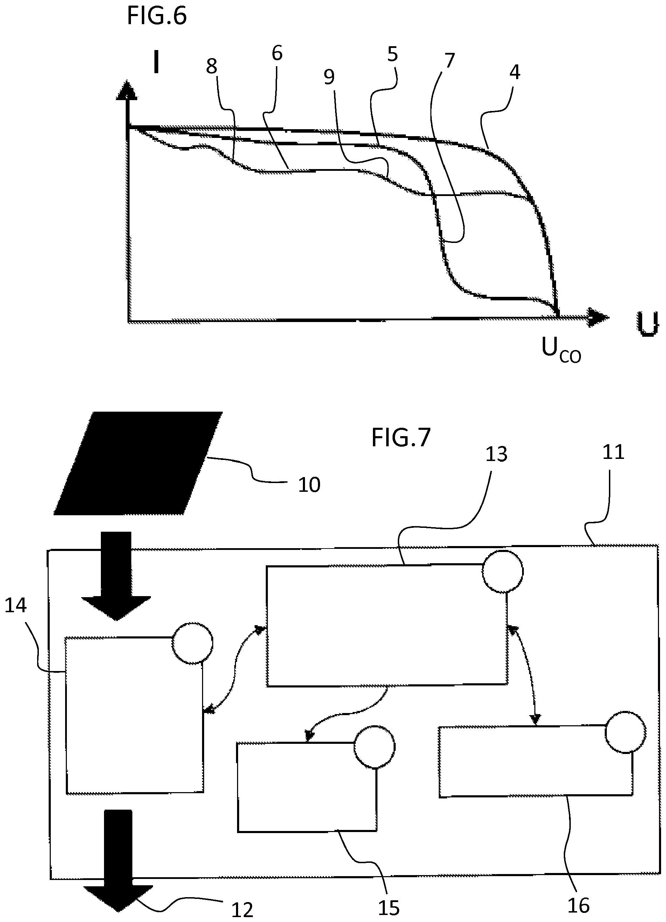

La figure 6 illustre trois courbes U(I) 4, 5, 6 obtenues selon respectivement trois scenarii différents lorsqu'un générateur photovoltaïque passe d'une situation en court-circuit à une situation en circuit ouvert. Chaque courbe U(I) est la somme des courbes U(I) de chacune des cellules photovoltaïques composant le générateur photovoltaïque. Des courbes équivalentes seraient obtenues pour un passage d'une situation en circuit ouvert à une situation en court-circuit.

La courbe 4 représente un générateur photovoltaïque dans lequel toutes les cellules photovoltaïques sont en bon état de fonctionnement. A l'ouverture du circuit, l'intensité va atteindre une valeur nulle alors que la tension atteindra une valeur maximale U_{CO} au bout d'un temps relativement court. La courbe 5 représente la même courbe obtenue dans le cas d'un générateur comprenant au moins une cellule photovoltaïque défectueuse. Cette courbe présente un décrochement 7 au cours duquel l'intensité chute plus rapidement alors que la tension augmente peu. La courbe 6 illustre un autre exemple dans lequel la courbe présente deux décrochements 8, 9, qui indiquent la présence d'au moins deux cellules photovoltaïques défectueuses. Dans tous les cas, la même valeur de tension U_{CO} est finalement atteinte, après un temps toutefois beaucoup plus long dans le cas des courbes 5, 6 pour les générateurs présentant au moins une cellule défaillante comme cela a été explicité ci-dessus. Ces exemples permettent d'illustrer plusieurs situations et enseignent que les courbes U(I) permettent d'obtenir les diagnostics suivants :
- il y a autant de défauts dans le dispositif que de décrochements 7, 8,9;
- plus le décrochement est important, plus la défaillance est importante.

Les explications précédentes vont être exploitées dans un mode d'exécution d'un dispositif photovoltaïque équipé d'un dispositif permettant le diagnostic de son fonctionnement, représenté sur la figure 7.

Le dispositif photovoltaïque de la figure 7 comprend un générateur photovoltaïque 10, qui peut comprendre une ou plusieurs cellules photovoltaïques, relié au réseau électrique par une liaison 12 par l'intermédiaire d'un onduleur 11. Cet onduleur est géré par un microcontrôleur ou CPU 13, dont la fonction principale est de déterminer le point de fonctionnement du générateur photovoltaïque 10 et sa liaison avec le réseau 12. Pour cela, il est en contact avec un bloc 14 de gestion de l'élévation de tension, un convertisseur DC - DC 15, et un bloc 16 de gestion de la publication sur le réseau de la production. Pour remplir sa fonction, le CPU 13 commande régulièrement les mesures suivantes :
- tension et courant fournis par le panneau DC ;
- mesure d'isolement côté DC ;
- mesure de présence réseau ;
- courant et tension injectés sur le réseau AC.

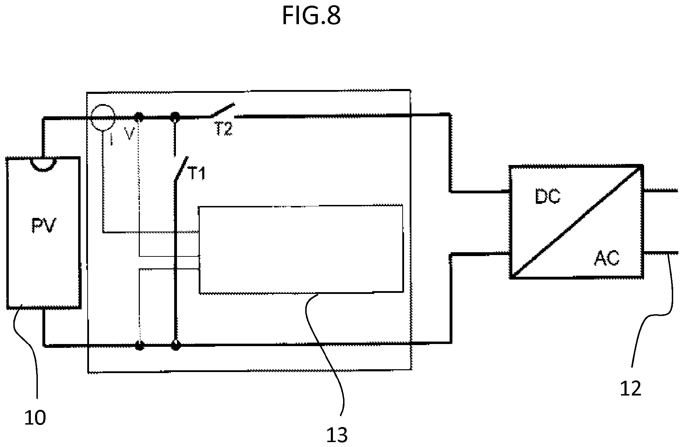

Selon l'invention, le dispositif photovoltaïque comprend de plus un dispositif de diagnostic intégré dans l'onduleur 11 décrit ci-dessus, dont le CPU met en oeuvre le procédé de diagnostic pour le générateur photovoltaïque et notamment de détection des défaillances, qui sera décrit plus loin. Le dispositif de diagnostic correspond au schéma électrique représenté sur la figure 8. Le CPU 13 de l'onduleur reçoit les mesures du courant I et de la tension V du générateur photovoltaïque 10 et commande deux interrupteurs T1, T2. En situation de fonctionnement normal de production électrique, le commutateur T2 est fermé alors que le commutateur T1 est ouvert. En variante, d'autres dispositifs sont possibles, notamment reposant sur au moins un commutateur. En variante, le dispositif de diagnostic pourrait être intégré dans tout autre boîtier distinct de l'onduleur, comme un boîtier positionné au niveau d'au moins une cellule photovoltaïque par exemple. Selon une variante de réalisation, un tel boîtier pourrait intégrer d'autres fonctions, comme une fonction de détection d'arc électrique au sein du générateur photovoltaïque. Ainsi, le procédé de l'invention est mis en oeuvre par un logiciel installé sur un microcontrôleur ou tout support, qui est ensuite intégré au dispositif photovoltaïque, et fonctionne sur la base de la réception de mesures en phase avec la commande du ou des commutateur(s).

Un tel dispositif peut permettre la mise en oeuvre du procédé de son diagnostic selon un premier mode de réalisation comprenant les étapes suivantes :
- ouverture du commutateur T2 pour obtenir le passage du générateur photovoltaïque d'un mode en circuit fermé à un mode en circuit ouvert ;
- mesure de la tension maximale U_{CO} stabilisée, obtenue aux bornes du générateur photovoltaïque au bout d'un certain temps (temps de stabilisation), quand l'intensité est nulle ;
- fermeture du commutateur T1 pour mettre le générateur photovoltaïque en court-circuit puis ouverture du commutateur T1 pour le remettre en circuit ouvert ;
- mesure de la tension U aux bornes du générateur photovoltaïque obtenue au bout d'un temps t prédéfini. Dans ce mode d'exécution, t est choisi égal à 15 microsecondes. Toute valeur relativement proche du temps nécessaire au générateur en situation de fonctionnement non défectueux pour atteindre un pourcentage prédéfini de la tension maximale stabilisée U_{CO} peut convenir, ce temps étant soit mesuré, soit estimé. Le temps t prédéfini sera donc suffisamment grand pour que la tension s'approche de la tension maximale U_{CO} du générateur, au moins pour le cas d'un générateur non défectueux. Ainsi, plus généralement, une valeur comprise entre 10⁻⁷ et 10⁻² secondes pourrait être choisie pour ce temps prédéfini ;
- comparaison de la tension mesurée U avec le pourcentage prédéfini de la tension maximale U_{CO}:
   - si la tension mesurée U atteint un certain pourcentage prédéfini de la tension maximale U_{CO}, alors le générateur est considéré comme fonctionnant normalement et le commutateur T2 est fermé pour remettre le générateur dans sa situation de production électrique normale. Le pourcentage prédéfini est fixé à 95% dans ce mode d'exécution. Il pourrait prendre d'autre valeurs, car il dépend du temps t prédéfini, et par exemple pourrait prendre toute autre valeur de préférence supérieure à 50% ;
   - si la tension mesurée U n'atteint pas le pourcentage prédéfini de la tension maximale U_{CO} alors le générateur est considéré comme défectueux.

Selon un autre mode de réalisation de l'invention, il est possible d'observer la courbe tension-intensité U(I) déterminée pendant que le dispositif passe d'un mode de fonctionnement en court-circuit à un mode en circuit ouvert. Pour cela, les étapes suivantes sont réalisées :
- fermeture du commutateur T1 pour remettre le générateur photovoltaïque en court-circuit puis ouverture du commutateur T1 pour le remettre en circuit ouvert ;
- mesure de plusieurs points de tension et de courant selon une fréquence f_{acq} prédéfinie, cette fréquence se trouvant avantageusement comprise entre 100 kHz et 1 MHz ;
- lorsque la tension atteint la valeur U_{CO}, alors le commutateur T2 est fermé pour remettre le générateur dans sa situation de production électrique normale ;
- les points mesurés sont transmis et analysés par le CPU 13 du dispositif photovoltaïque, qui peut ainsi déduire le nombre de défauts et l'importance de la dégradation.
Selon une variante de réalisation en mode réciproque, seule la première étape est modifiée ; le commutateur T1 est d'abord ouvert puis fermé de sorte de générer un passage d'un circuit ouvert vers un court-circuit.

En variante, les deux modes d'exécution décrits précédemment peuvent être cumulés. Par exemple, le premier mode d'exécution reposant sur l'analyse de l'évolution en fonction du temps de la tension lorsqu'il passe d'un mode de fonctionnement en court-circuit à un mode de fonctionnement en circuit ouvert peut être suivi dans le cas où un défaut est détecté de la détermination et de l'observation de l'évolution de la courbe U(I) afin d'en déduire des informations complémentaires sur les défauts du dispositif.

Selon une réalisation avantageuse de l'invention, le temps nécessaire pour la mise en oeuvre du diagnostic est suffisamment faible pour permettre son exécution sans l'arrêt complet de l'onduleur 11, qui nécessiterait alors un temps important dans le cas contraire, pouvant atteindre plusieurs minutes, pour produire de nouveau sa puissance maximale. Pour cela, il faut noter que l'onduleur comprend un bus capacitif permettant de stocker de l'énergie correspondant à au moins une milliseconde d'injection sur le réseau. Le temps nécessaire pour que la tension du générateur photovoltaïque atteigne sa valeur maximale lors du passage en circuit ouvert dépend du courant et de la capacité équivalente du générateur 10. En remarque, ce temps varie faiblement en fonction de l'irradiation et des caractéristiques intrinsèques des cellules. Ainsi, en choisissant un transistor de puissance rapide, des composants T1, T2, à commutation rapide, par exemple de l'ordre de la microseconde, et/ou des moyens de mesure appropriés, il est possible de mettre en oeuvre le diagnostic en un temps inférieur à 1 milliseconde, ce qui permet de ne pas arrêter l'onduleur et de ne pas pénaliser la production électrique. Le procédé de diagnostic est mis en oeuvre périodiquement, et permet ainsi de vérifier le dispositif en temps réel.

Un procédé de diagnostic pour le dispositif photovoltaïque a été décrit à titre d'exemple selon le premier mode d'exécution de l'invention. Bien entendu, d'autres variantes sont possibles, reposant sur la variation du temps nécessaire pour atteindre la tension maximale U_{CO} aux bornes du générateur en situation de circuit ouvert. Cette tension maximale n'est pas obligatoirement mesurée à chaque mise en oeuvre du procédé de diagnostic mais elle peut par exemple être mesurée une seule fois lorsque le générateur est neuf, en fonctionnement normal non défectueux, et mémorisée. De même, le temps nécessaire pour atteindre cette valeur peut être mesuré simultanément, et mémorisé pour servir de base aux étapes de diagnostic.

Ainsi, une variante possible du premier mode d'exécution du procédé de diagnostic du générateur peut consister à systématiquement attendre, lors du passage en circuit ouvert du générateur, que la tension atteigne la tension maximale, mesurer le temps nécessaire et le comparer au temps normal en cas de bon fonctionnement. Si ce temps dépasse le temps normal d'un pourcentage prédéfini, alors le générateur est considéré comme étant défectueux.

Le procédé de diagnostic a été décrit sur la base d'un dispositif de diagnostic correspondant au schéma électrique représenté sur la figure 8. Selon une variante avantageuse, le diagnostic pourrait être fait en utilisant la structure d'entrée d'un onduleur photovoltaïque. Classiquement, ces onduleurs utilisent des composants d'électronique de puissance, soit en série, soit en parallèle, soit les deux, pouvant permettre de déconnecter la partie onduleur (étage convertisseur DC/AC) de la partie hacheur (étage convertisseur DC/DC) de l'appareil « onduleur photovoltaïque » et/ou de réaliser la fonction de conversion DC/DC. Ces composants peuvent effectuer le passage de court-circuit à circuit ouvert du (des) générateur(s) photovoltaïque(s) connecté(s) en entrée et ainsi permettre de faire le diagnostic. Cette fonctionnalité pourrait ainsi être mise en oeuvre facilement et principalement grâce à des adaptations logicielles des onduleurs existants.

L'invention atteint ainsi les objets recherchés, et permet un diagnostic précis et rapide d'un générateur photovoltaïque, permet notamment de déterminer en cas de baisse de production si la baisse provient d'un défaut du générateur photovoltaïque ou est lié à un câblage ou connectique défectueux. Le personnel de maintenance peut ainsi être averti rapidement et avec précision de la défaillance

## Revendications

1. Procédé de diagnostic pour un générateur photovoltaïque **caractérisé en ce qu'**il met en oeuvre une étape d'observation de l'évolution de sa tension (U) en fonction du temps pendant qu'il passe d'un mode de fonctionnement en court-circuit à un mode en circuit ouvert ou réciproquement d'un mode de fonctionnement en circuit ouvert à un mode en court-circuit.

2. Procédé de diagnostic pour un générateur photovoltaïque selon la revendication précédente, **caractérisé en ce qu'**il comprend en outre une étape de mesure du temps normal nécessaire pour atteindre une tension maximale (U_{CO}) lorsque le générateur photovoltaïque passe d'un mode de fonctionnement en court-circuit à un mode en circuit ouvert dans un état non défectueux et/ou **en ce qu'**il comprend en outre une étape de mesure de la tension maximale (U_{CO}).

3. Procédé de diagnostic pour un générateur photovoltaïque selon la revendication précédente, **caractérisé en ce que** l'étape de mesure de la tension maximale (U_{CO}) est réalisée après le passage du générateur photovoltaïque d'un mode de fonctionnement normal à un mode en circuit ouvert.

4. Procédé de diagnostic pour un générateur photovoltaïque selon l'une des revendications précédentes, **caractérisé en ce qu'**il comprend une étape de mesure du temps nécessaire pour atteindre un pourcentage prédéfini de la tension maximale (U_{CO}) lorsqu'il passe d'un mode de fonctionnement en court-circuit à un mode en circuit ouvert, et une étape de comparaison de ce temps avec le temps normal nécessaire dans le cas du générateur photovoltaïque en état de fonctionnement non défectueux, le générateur photovoltaïque étant considéré comme défectueux si ce temps dépasse un seuil prédéfini.

5. Procédé de diagnostic pour un générateur photovoltaïque selon l'une des revendications 1 à 3, **caractérisé en ce qu'**il comprend une étape de mesure de la tension (U) aux bornes du générateur au bout d'un temps prédéfini lorsqu'il passe d'un mode de fonctionnement en court-circuit à un mode en circuit ouvert et une étape de comparaison de cette tension avec la tension normale atteinte dans le cas du générateur photovoltaïque en état de fonctionnement non défectueux, le générateur photovoltaïque étant considéré comme défectueux si cette tension est inférieure à un seuil prédéfini.

6. Procédé de diagnostic pour un générateur photovoltaïque selon la revendication précédente, **caractérisé en ce qu'**il comprend les étapes supplémentaires suivantes :
- ouverture d'un premier commutateur (T2) (en anglais switch) pour obtenir le passage du générateur photovoltaïque de la position de circuit fermé à celle de circuit ouvert, en le déconnectant de sa charge ;
- mesure de la tension maximale (U_{CO}) stabilisée, obtenue aux bornes du générateur photovoltaïque ;
- fermeture d'un second commutateur (T1) pour mettre le générateur photovoltaïque en court-circuit puis ouverture de ce second commutateur (T1) pour le remettre en circuit ouvert ;
- mesure de la tension (U) aux bornes du générateur photovoltaïque obtenue au bout d'un temps (t) prédéfini et comparaison de la tension mesurée (U) avec la tension maximale (U_{CO}) pour déterminer l'état défectueux ou non du générateur photovoltaïque ;
- fermeture du premier commutateur (T2) pour remettre le générateur photovoltaïque dans sa situation de production électrique normale en liaison avec sa charge.

7. Procédé de diagnostic pour un générateur photovoltaïque selon la revendication 5 ou 6, **caractérisé en ce que** le temps prédéfini est compris entre 10⁻⁷ et 10⁻² secondes et/ou **en ce que** le pourcentage prédéfini de la tension maximale (U_{CO}) est supérieur à 50 %.

8. Procédé de diagnostic pour un générateur photovoltaïque selon l'une des revendications précédentes, **caractérisé en ce qu'**en cas de diagnostic de la défaillance du générateur photovoltaïque, le procédé détermine la courbe de l'évolution U(I) de sa tension (U) en fonction du courant (I).

9. Procédé de diagnostic pour un générateur photovoltaïque selon la revendication 1, **caractérisé en ce que** l'étape d'observation de l'évolution de sa tension (U) comprend de plus l'observation de l'évolution U(I) de sa tension (U) en fonction du courant (I).

10. Procédé de diagnostic pour un générateur photovoltaïque selon la revendication précédente, **caractérisé en ce qu'**il comprend une étape de détection des décrochements (7, 8, 9) de la courbe tension-intensité pour en déduire le nombre de défauts ainsi que l'importance de la défaillance.

11. Procédé de diagnostic pour un générateur photovoltaïque selon la revendication précédente, **caractérisé en ce qu'**il comprend les étapes supplémentaires suivantes :
- ouverture d'un premier commutateur (T2) (en anglais switch) pour obtenir le passage du générateur photovoltaïque de la position de circuit fermé à celle de circuit ouvert, en le déconnectant de sa charge ;
- mesure de la tension maximale (U_{CO}) stabilisée, obtenue aux bornes du générateur photovoltaïque ;
- fermeture d'un second commutateur (T1) pour mettre le générateur photovoltaïque en court-circuit puis ouverture de ce second commutateur (T1) pour le remettre en circuit ouvert ;
- mesure de la tension (U) et du courant (I) aux bornes du générateur photovoltaïque jusqu'à ce que la tension (U) atteigne la tension maximale (U_{CO}) pour obtenir la courbe U(I) ;
- fermeture du premier commutateur (T2) pour remettre le générateur photovoltaïque dans sa situation de production électrique normale en liaison avec sa charge.

12. Procédé de diagnostic pour un générateur photovoltaïque selon l'une des revendications précédentes, **caractérisé en ce que** le passage d'un mode de fonctionnement en court-circuit à un mode en circuit ouvert ou réciproquement est réalisé par un onduleur (11).

13. Dispositif photovoltaïque comprenant un générateur photovoltaïque comprenant plusieurs cellules photovoltaïques, **caractérisé en ce qu'**il comprend au moins deux commutateurs (T1 ; T2) pour permettre le passage d'au moins une cellule du générateur photovoltaïque d'un mode de fonctionnement en court-circuit à un mode en circuit ouvert ou réciproquement, et **en ce qu'**il comprend un microcontrôleur ou CPU (13) mettant en oeuvre le procédé de diagnostic pour le générateur photovoltaïque selon l'une des revendications précédentes.

14. Dispositif photovoltaïque selon la revendication précédente, **caractérisé en ce qu'**un premier commutateur (T2) est apte à relier ou non le générateur photovoltaïque à une charge extérieure comme une batterie ou un réseau électrique, et **en ce qu'**au moins un second commutateur (T1) est en parallèle sur au moins une cellule du générateur photovoltaïque.

15. Dispositif photovoltaïque selon l'une des revendications 13 ou 14, **caractérisé en ce que** le microcontrôleur ou CPU (13) est celui d'un onduleur (11) apte à relier le dispositif photovoltaïque à un réseau électrique ou **en ce que** le microcontrôleur ou CPU (13) est intégré dans un boîtier disposé au niveau du générateur photovoltaïque.

## Patentansprüche

1. Diagnoseverfahren für einen Photovoltaikgenerator, **dadurch gekennzeichnet, dass** es einen Schritt der Beobachtung der Veränderung seiner Spannung (U) in Abhängigkeit von der Zeit, während er von einer Betriebsweise im Kurzschlussbetrieb zu einem Betrieb im offenen Stromkreis oder umgekehrt von einer Betriebsweise im offenen Stromkreis zu einem Kurzschlussbetrieb übergeht, umfasst.

2. Diagnoseverfahren für einen Photovoltaikgenerator nach dem vorhergehenden Anspruch, **dadurch gekennzeichnet, dass** es außerdem einen Schritt der Messung der normalen Zeit umfasst, die erforderlich ist, um eine maximale Spannung (U_{CO}) zu erreichen, wenn der Photovoltaikgenerator von einer Betriebsweise im Kurzschlussbetrieb zu einem Betrieb im offenen Stromkreis in einem nicht defekten Zustand übergeht, und/oder dadurch, dass er außerdem einen Schritt der Messung der maximalen Spannung (U_{CO}) umfasst.

3. Diagnoseverfahren für einen Photovoltaikgenerator nach dem vorhergehenden Anspruch, **dadurch gekennzeichnet, dass** der Schritt der Messung der maximalen Spannung (U_{CO}) nach dem Übergang des Photovoltaikgenerators von einer normalen Betriebsweise zu einem Betrieb im offenen Stromkreis durchgeführt wird.

4. Diagnoseverfahren für einen Photovoltaikgenerator nach einem der vorhergehenden Ansprüche, **dadurch gekennzeichnet, dass** es einen Schritt der Messung der Zeit umfasst, die erforderlich ist, um einen vordefinierten Prozentsatz der maximalen Spannung (U_{CO}) zu erreichen, wenn er von einer Betriebsweise im Kurzschlussbetrieb zu einem Betrieb im offenen Stromkreis übergeht, und einen Schritt des Vergleichs dieser Zeit mit der normalen Zeit, die im Falle des Photovoltaikgenerators in einem nicht defekten Betriebszustand erforderlich ist, wobei der Photovoltaikgenerator als defekt angesehen wird, falls diese Zeit einen vordefinierten Schwellenwert überschreitet.

5. Diagnoseverfahren für einen Photovoltaikgenerator nach einem der Ansprüche 1 bis 3, **dadurch gekennzeichnet, dass** es einen Schritt der Messung der Spannung (U) an den Klemmen des Generators am Ende einer vordefinierten Zeit umfasst, wenn er von einer Betriebsweise im Kurzschlussbetrieb zu einem Betrieb im offenen Stromkreis übergeht, und einen Schritt des Vergleichs dieser Spannung mit der normalen Spannung, die im Falle des Photovoltaikgenerators in einem nicht defekten Betriebszustand erreicht wird, wobei der Photovoltaikgenerator als defekt angesehen wird, falls diese Spannung kleiner als ein vordefinierter Schwellenwert ist.

6. Diagnoseverfahren für einen Photovoltaikgenerator nach dem vorhergehenden Anspruch, **dadurch gekennzeichnet, dass** es die folgenden zusätzlichen Schritte umfasst:
- Öffnen eines ersten Schalters (T2) (englisch "switch"), um den Übergang des Photovoltaikgenerators aus der Position des geschlossenen Stromkreises in die des offenen Stromkreises zu bewirken, indem er von seiner Last getrennt wird;
- Messung der stabilisierten maximalen Spannung (U_{CO}), die an den Klemmen des Photovoltaikgenerators erhalten wird;
- Schließen eines zweiten Schalters (T1), um den Photovoltaikgenerator kurzzuschließen, danach Öffnung dieses zweiten Schalters (T1), um ihn wieder in einen offenen Stromkreis zu schalten;
- Messung der Spannung (U) an den Klemmen des Photovoltaikgenerators, die am Ende einer vordefinierten Zeit (t) erhalten wird, und Vergleich der gemessenen Spannung (U) mit der maximalen Spannung (U_{CO}), um den defekten oder nicht defekten Zustand des Photovoltaikgenerators zu bestimmen;
- Schließen des ersten Schalters (T2), um den Photovoltaikgenerator wieder in seine Situation der normalen Stromerzeugung in Verbindung mit seiner Last zu bringen.

7. Diagnoseverfahren für einen Photovoltaikgenerator nach Anspruch 5 oder 6, **dadurch gekennzeichnet, dass** die vordefinierte Zeit zwischen 10⁻⁷ und 10⁻² Sekunden liegt, und/oder dadurch, dass der vordefinierte Prozentsatz der maximalen Spannung (U_{CO}) größer als 50 % ist.

8. Diagnoseverfahren für einen Photovoltaikgenerator nach einem der vorhergehenden Ansprüche, **dadurch gekennzeichnet, dass** im Falle der Diagnose des Ausfalls des Photovoltaikgenerators das Verfahren die Kurve der Veränderung U(I) seiner Spannung (U) in Abhängigkeit von der Stromstärke (I) bestimmt.

9. Diagnoseverfahren für einen Photovoltaikgenerator nach Anspruch 1, **dadurch gekennzeichnet, dass** der Schritt der Beobachtung der Veränderung seiner Spannung (U) außerdem die Beobachtung der Veränderung U(I) seiner Spannung (U) in Abhängigkeit von der Stromstärke (I) umfasst.

10. Diagnoseverfahren für einen Photovoltaikgenerator nach dem vorhergehenden Anspruch, **dadurch gekennzeichnet, dass** es einen Schritt der Detektion der Stellen eines starken Abfalls (7, 8, 9) der Spannungs-Strom-Kurve umfasst, um daraus die Anzahl von Fehlern sowie das Ausmaß des Ausfalls abzuleiten.

11. Diagnoseverfahren für einen Photovoltaikgenerator nach dem vorhergehenden Anspruch, **dadurch gekennzeichnet, dass** es die folgenden zusätzlichen Schritte umfasst:
- Öffnen eines ersten Schalters (T2) (englisch "switch"), um den Übergang des Photovoltaikgenerators aus der Position des geschlossenen Stromkreises in die des offenen Stromkreises zu bewirken, indem er von seiner Last getrennt wird;
- Messung der stabilisierten maximalen Spannung (U_{CO}), die an den Klemmen des Photovoltaikgenerators erhalten wird;
- Schließen eines zweiten Schalters (T1), um den Photovoltaikgenerator kurzzuschließen, danach Öffnung dieses zweiten Schalters (T1), um ihn wieder in einen offenen Stromkreis zu schalten;
- Messung der Spannung (U) und des Stroms (I) an den Klemmen des Photovoltaikgenerators, bis die Spannung (U) die maximale Spannung (U_{CO}) erreicht, um die Kurve U(I) zu erhalten;
- Schließen des ersten Schalters (T2), um den Photovoltaikgenerator wieder in seine Situation der normalen Stromerzeugung in Verbindung mit seiner Last zu bringen.

12. Diagnoseverfahren für einen Photovoltaikgenerator nach einem der vorhergehenden Ansprüche, **dadurch gekennzeichnet, dass** der Übergang von einer Betriebsweise im Kurzschlussbetrieb zu einem Betrieb im offenen Stromkreis oder umgekehrt durch einen Wechselrichter (11) realisiert wird.

13. Photovoltaische Vorrichtung, welche einen Photovoltaikgenerator umfasst, der mehrere photovoltaische Zellen umfasst, **dadurch gekennzeichnet, dass** sie wenigstens zwei Schalter (T1; T2) umfasst, um den Übergang wenigstens einer Zelle des Photovoltaikgenerators von einer Betriebsweise im Kurzschlussbetrieb zu einem Betrieb im offenen Stromkreis oder umgekehrt zu ermöglichen, und dadurch, dass sie einen Mikrocontroller oder eine CPU (13) umfasst, der bzw. die das Diagnoseverfahren für den Photovoltaikgenerator nach einem der vorhergehenden Ansprüche durchführt.

14. Photovoltaische Vorrichtung nach dem vorhergehenden Anspruch, **dadurch gekennzeichnet, dass** ein erster Schalter (T2) geeignet ist, den Photovoltaikgenerator mit einer äußeren Last wie einer Batterie oder einem Stromnetz zu verbinden oder nicht, und dadurch, dass wenigstens ein zweiter Schalter (T1) zu wenigstens einer Zelle des Photovoltaikgenerators parallelgeschaltet ist.

15. Photovoltaische Vorrichtung nach einem der Ansprüche 13 oder 14, **dadurch gekennzeichnet, dass** der Mikrocontroller oder die CPU (13) derjenige bzw. diejenige eines Wechselrichters (11) ist, der geeignet ist, die photovoltaische Vorrichtung mit einem Stromnetz zu verbinden, oder dadurch, dass der Mikrocontroller oder die CPU (13) in ein Gehäuse integriert ist, das an dem Photovoltaikgenerator angeordnet ist.

## Claims

1. Method of diagnosis for a photovoltaic generator, **characterized in that** it implements a step of observing the evolution of its voltage (U) as a function of time while it passes from a short-circuit mode of operation to an open-circuit mode or vice versa from an open-circuit mode of operation to a short-circuit mode.

2. Method of diagnosis for a photovoltaic generator according to the preceding claim, **characterized in that** it furthermore comprises a step of measuring the normal time required to attain a maximum voltage (Uco) when the photovoltaic generator passes from a short-circuit mode of operation to an open-circuit mode in a non-defective state and/or **in that** it furthermore comprises a step of measuring the maximum voltage (Uco).

3. Method of diagnosis for a photovoltaic generator according to the preceding claim, **characterized in that** the step of measuring the maximum voltage (Uco) is carried out after the photovoltaic generator has passed from a normal mode of operation to an open-circuit mode.

4. Method of diagnosis for a photovoltaic generator according to one of the preceding claims, **characterized in that** it comprises a step of measuring the time required to attain a predefined percentage of the maximum voltage (Uco) when it passes from a short-circuit mode of operation to an open-circuit mode, and a step of comparing this time with the normal time required in the case of the photovoltaic generator in the non-defective operating state, the photovoltaic generator being considered to be defective if this time exceeds a predefined threshold.

5. Method of diagnosis for a photovoltaic generator according to one of Claims 1 to 3, **characterized in that** it comprises a step of measuring the voltage (U) across the terminals of the photovoltaic generator after a predefined time when it passes from a short-circuit mode of operation to an open-circuit mode and a step of comparing this voltage with the normal voltage attained in the case of the photovoltaic generator in the non-defective operating state, the photovoltaic generator being considered to be defective if this voltage is below a predefined threshold.

6. Method of diagnosis for a photovoltaic generator according to the preceding claim, **characterized in that** it comprises the following additional steps:
- opening of a first switch (T2) so as to cause the photovoltaic generator to pass from the closed-circuit position to the open-circuit position, by disconnecting it from its load;
- measurement of the stabilized maximum voltage (Uco), obtained across the terminals of the photovoltaic generator;
- closing of a second switch (T1) so as to place the photovoltaic generator in short-circuit and then opening of this second switch (T1) so as to place it back in open-circuit;
- measurement of the voltage (U) across the terminals of the photovoltaic generator obtained after a predefined time (t) and comparison of the measured voltage (U) with the maximum voltage (Uco) so as to determine the defective or non-defective state of the photovoltaic generator;
- closing of the first switch (T2) so as to place the photovoltaic generator back in its normal electrical production situation linked up with its load.

7. Method of diagnosis for a photovoltaic generator according to Claim 5 or 6, **characterized in that** the predefined time lies between 10⁻⁷ and 10⁻² seconds and/or **in that** the predefined percentage of the maximum voltage (Uco) is greater than 50 %.

8. Method of diagnosis for a photovoltaic generator according to one of the preceding claims, **characterized in that** in the case of diagnosing the failure of the photovoltaic generator, the method determines the curve of the evolution U(I) of its voltage (U) as a function of the current (I).

9. Method of diagnosis for a photovoltaic generator according to Claim 1, **characterized in that** the step of observing the evolution of its voltage (U) moreover comprises the observation of the evolution U(I) of its voltage (U) as a function of the current (I).

10. Method of diagnosis for a photovoltaic generator according to the preceding claim, **characterized in that** it comprises a step of detecting the kinks (7, 8, 9) in the voltage-current curve so as to deduce therefrom the number of defects as well as the significance of the failure.

11. Method of diagnosis for a photovoltaic generator according to the preceding claim, **characterized in that** it comprises the following additional steps:
- opening of a first switch (T2) so as to cause the photovoltaic generator to pass from the closed-circuit position to the open-circuit position, by disconnecting it from its load;
- measurement of the stabilized maximum voltage (Uco), obtained across the terminals of the photovoltaic generator;
- closing of a second switch (T1) so as to place the photovoltaic generator in short-circuit and then opening of this second switch (T1) so as to place it back in open-circuit;
- measurement of the voltage (U) and of the current (I) across the terminals of the photovoltaic generator until the voltage (U) attains the maximum voltage (Uco) so as to obtain the curve U(I);
- closing of the first switch (T2) so as to place the photovoltaic generator back in its normal electrical production situation linked up with its load.

12. Method of diagnosis for a photovoltaic generator according to one of the preceding claims, **characterized in that** the passage from a short-circuit mode of operation to an open-circuit mode or vice versa is effected by an inverter (11).

13. Photovoltaic device comprising a photovoltaic generator comprising several photovoltaic cells, **characterized in that** it comprises at least two switches (T1; T2) so as to allow at least one cell of the photovoltaic generator to pass from a short-circuit mode of operation to an open-circuit mode or vice versa, and **in that** it comprises a microcontroller or CPU (13) implementing the method of diagnosis for the photovoltaic generator according to one of the preceding claims.

14. Photovoltaic device according to claim 13, **characterized in that** a first switch (T2) is able to link or not the photovoltaic generator to an external load such as a battery or an electrical network, and **in that** at least one second switch (T1) is in parallel with at least one cell of the photovoltaic generator.

15. Photovoltaic device according to one of Claims 13 or 14, **characterized in that** the microcontroller or CPU (13) is that of an inverter (11) able to link the photovoltaic device to an electrical network or **in that** the microcontroller or CPU (13) is integrated into a housing disposed at the level of the photovoltaic generator.
